# EUROPEAN PATENT APPLICATION

(11) **EP 1 564 269 A1**
(43) Date of publication of application: **17.08.2005**
(21) Application number: 03811131.6
(22) Date of filing: 13.11.2003
(51) Int. Cl.: C09D 183/04, C09D 183/02, H01L 21/312, H01L 21/768, C08G 77/44

(54) **COMPOSITION FOR POROUS FILM FORMATION, POROUS FILM, PROCESS FOR PRODUCING THE SAME, INTERLAYER INSULATION FILM AND SEMICONDUCTOR DEVICE**

(30) Priority: 13.11.2002 JP 2002329127
(71) Applicant: MATSUSHITA ELECTRIC INDUSTRIAL CO., LTD., Kadoma-shi, Osaka 571-8501 (JP)
(72) Inventor: HAMADA, Yoshitaka c/o SHIN-ETSU CHEMICAL CO., LTD, Naka Kubiki-gun, Niigata 942-8601 (JP); YAGIHASHI, Fujio c/o SHIN-ETSU CHEMICAL CO., LTD, Naka Kubiki-gun, Niigata 942-8601 (JP); NAKAGAWA, Hideo, Omihachiman-shi, Shiga 523-0064 (JP); SASAGO, Masaru, Hirakata-shi, Osaka 573-0007 (JP)
(74) Representative: Harrison Goddard Foote
(86) International application number: PCT/JP2003/014439
(87) International publication number: WO 2004/044074

(57) **Abstract**

A composition for film formation from which a porous film excelling in dielectric characteristics, adherence, coating film uniformity and mechanical strength and realizing reduced moisture absorption can be prepared; a porous film and a process for producing the same; and a highly reliable semiconductor device of high performance wherein the porous film is incorporated. In particular, a composition for film formation, obtained by performing hydrolytic condensation under acid or alkali conditions of a mixture of 100 parts by weight of at least one compound selected from the group consisting of hydrolyzable silicon compounds of the following general formulae R<1>aSiZ<1>4-a (1) and R<2>b(Z<2>)3-bSi-Y-Si(R<3>)cZ<3>3-c (2) and products of hydrolytic condensation of portion thereof and 0.1 to 20 parts by weight of at least one crosslinking agent selected from the group consisting of cyclic or multi-branched oligomers of limited structures represented by the following general formulae (3) to (8):

[R<4>(H)SiO]e[R<5>(Z<4>)SiO]f (3); (R<6>SiO3/2)g[R<7>(H)SiO]h[R<8>(Z<5>)SiO]i (4);

(HSiO3/2)j(Z<6>SiO3/2)k (5);

[H(Me)2SiO1/2]L[Z<7>(Me)2SiO1/2]m(R<9>SiO3/2)n[R<10>(Z<8>)SiO]o (6);

[H(Me)2SiO1/2]p[Z<9>(Me)2SiO1/2]q(SiO2)r(Z<10>SiO3/2)s (7);

(Z<11>3SiO1/2)t(R<11>2SiO)u(R<12>SiO3/2)v[R<13>(Z<12>)SiO]w(SiO2)x(Z<13>SiO3/2)y (8).

## Description

### Technical Field

The present invention relates to a composition for film formation, which can be formed into a porous film that excels in dielectric properties, adhesion, film consistency and mechanical strength, and has reduced absorption; a porous film and a method for forming the same; and a semiconductor device, which contains the porous film inside.

### Background Art

In the fabrication of semiconductor integrated circuits, as the circuits are packed tighter, an increase in interconnection capacitance, which is a parasitic capacitance between metal interconnections, leads to an increase in interconnection delay time, thereby hindering the enhancement of the performance of semiconductor circuits. The interconnection delay time is called an RC delay, which is in proportion to the product of the electric resistance of the metal interconnections and the static capacitance between the interconnections. Accordingly, reducing the interconnection delay time requires reducing the resistance of metal interconnections or the interconnection capacitance. The reduction in the interconnection capacitance can prevent a densely packed semiconductor device from causing an interconnection delay, thereby realizing a faster semiconductor device with reduced power consumption.

One method for reducing interconnection capacitance is to reduce the relative permittivity (dielectric constant) of an interlevel insulator film disposed between metal interconnections. As such an insulator film with a low relative permittivity, it has been considered to use a porous film instead of a silicon oxide film, which has been used conventionally. A porous film can be said to be the only practical film as a material with a relative permittivity of 2.0 or less, and various methods for forming a porous film have been proposed

A first method for forming a porous film is as follows: a precursor solution of a siloxane polymer containing a thermally unstable organic component is synthesized; then the precursor solution is applied on the substrate to form a coating film; and later, a heat treatment is applied to decompose and volatilize the organic component. The result is a number of micro-pores formed in the film.

As a second method for forming a porous film, it is well known to carry out processing as follows: a silica sol solution is applied onto a substrate by coating or using a CVD method so as to form a wet gel; and then the silica sol is subjected to a condensation reaction while restricting volume reduction by controlling the speed of the solvent evaporation from the wet gel through solvent replacement and the like.

As a third method for forming a porous film, it is well known that a silica micro-particle solution is applied on a substrate to form a coating film, and then the coating film is sintered to form a number of micro-pores between silica micro-particles.

As a fourth method, Japanese Patent Provisional Publication No. 2000-44875 proposes a composition for porous film formation, which is characterized by containing a compound having (A) a component expressed by (R^{1'})_{n'}Si(OR^{2'})_{4-n'} (R^{1'} and R^{2'} are univalent organic radicals, and n' is an integer of 0 to 2); (B) a metal chelate compound; and (C) a compound having a polyalkylene oxide structure.

However, these methods have respective major drawbacks as follows.

In the first method for forming a porous film, the synthesis of the precursor solution of the siloxane polymer increases the cost. In addition, the formation of the coating film by coating the precursor solution increases the amount of silanol groups remaining in the coating film, which causes a degassing phenomenon indicating the evaporation of water and the like in the heat treatment process that is conducted later and, which also deteriorates the film quality due to the porous film absorbing humidity.

In the second method for forming a porous film, the speed control of the evaporation of the solvent from the wet gel requires a special type of coating device, which increases the cost. In addition, a significant amount of silanol remains on the surface of the micro-pores, which must be silanized because otherwise hygroscopicity is high and the film quality decreases. The silanization makes the process more complicated. In the case where a wet gel is formed by the CVD process, it is necessary to use a special type of CVD device, which is different from the plasma CVD device generally used in the semiconductor process, thereby also increasing the cost.

In the third method for forming a porous film, the diameter of the micro-pores, which is determined by the accumulation structure of the silica micro-particles, becomes very large. This makes it difficult to set the relative permittivity of the porous film to 2 or below.

In the case of the fourth method, out of the three components (A), (B), and (C), the metal chelate compound of (B) is essential to increase the compatibility of the components (A) and (C), and to make the thickness of the coating film uniform after being hardened. However, it is not preferable because it makes the manufacturing process complicated and increases the cost. Therefore, it is desired to develop a material, which enables a homogeneous solution to be formed without a chelate component and the coating film to be flat after being hardened.

Moreover, in any of the above methods, there is a problem of lowed mechanical strength of the formed porous film itself. It is believed that in order to maintain the practical level of the strength, it believed to be effective that the pores having small and uniform pore diameter are scattered uniformly in the film

As mentioned above, because conventional material produces pores having large diameter during the formation of porous film, there is a problem that it is difficult to produce the film having the low dielectric constant. There is also a problem that it costs more to form the porous film having fine empty pores. When the conventional porous film is used as an insulator film in multi-level interconnects of the semiconductor device, there is further a problem such that it does not have the mechanical strength required for the semiconductor processing.

When the dielectric constant of the porous film used as an insulator film in multi-level interconnects of the semiconductor device increases, the RC delay increases. Consequently, there is a large problem that the performance of the semiconductor device (high speed and low power consumption) has not been improved. There is also a problem that the porous film having low mechanical strength lowers the reliability of the semiconductor device.

### Disclosure of Invention

An object of the invention is to provide a composition for forming film which can form a porous film excelling in dielectric constant, adhesiveness, uniformity of the film, mechanical strength and having low hygroscopicity. Moreover, an object of the invention is to provide a high-performing and highly reliable semiconductor device comprising the porous film inside.

The inventors have found that the silica material can improve the mechanical strength of the film by adding a cross-linking agent in alkoxysilane hydrolysate which is a silica precursor, wherein the cross-linking agent will become a nucleus for cross-linking. Specifically, the inventors have found that when a polyfunctional siloxane oligomer whose structure has been controlled to some degree is added as a cross-linking agent, the coating liquid can be prepared without producing gel. Thus, the invention has been completed. The increased film strength can produce film having low dielectric constant in a stable manner because pores formed during the sintering process can be maintained stably through the following heat treatment and the like. The cross-linking agent can be added together with the other alkoxysilane fro co-hydrolysis or can be added into a solution in which the alkoxysilane has been hydrolyzed. Herein, when the cross-linking agent to be added does not have sufficient structural regularity, gel may be produced during the hydrolysis step so that the stable composition for coating cannot be obtained. Although the method for producing the cross-linking agent is not especially limited, in order to improve the structural regularity of the cross-linking agent, the precursor which contains the Si-H bond is produced and then the hydrolysable group can be introduced in the dehydrogenation reaction. Alternatively, the Si-H bond-containing compound can be introduced to the reaction system and causes a dehydrogenation and condensation reaction in the presence of alkali catalyst or the like so that the compound functions as a cross-linking agent.

According to the invention, provided is a composition for forming porous film obtainable by hydrolysis and condensation, in an acidic alkaline condition, of a mixture of 100 parts by weight of one or more compounds selected of the group consisting of hydrolysable silicon compounds represented by Formulas (1) and (2) and partially hydrolyzed and condensed products of the hydrolysable silicon compounds represented by Formulas (1) and (2):

R¹ ₐSiZ¹ ₄₋ₐ (1)

R² _{b}(Z²)_{3-b}Si-Y-Si(R³)_{c}Z³ _{3-c} (2)

wherein R¹, R² and R³ each independently represents a monovalent hydrocarbon group which may be substituted or non-substituted; Z¹, Z² and Z³ each independently represents a hydrolysable group; Y is independently selected from the group consisting of an oxygen atom, a phenylene group and an alkylene group having carbon atom number of 1 to 6; a independently represents an integer of 0 to 3; b and c each independently represents an integer of 0 to 2;
and 0.1 to 20 parts by weight of one or more cross-linking agents selected from the group consisting of structure-controlled cyclic or multi-branched oligomers represented by Formulas (3) to (8):

[R⁴(H)SiO]_{c}[R⁵(Z⁴)SiO]_{f} (3)

(R⁶SiO_{3/2})_{g}[R⁷(H)SiO]ₕ[R⁸(Z⁵)SiO]ᵢ (4)

(HSiO_{3/2})ⱼ(Z⁶SiO_{3/2})ₖ (5)

[H(Me)₂SiO_{1/2}]_{L}[Z⁷(Me)₂SiO_{1/2}]ₘ(R⁹SiO_{3/2})ₙ[R¹⁰(Z⁸)SiO]ₒ (6)

[H(Me)₂SiO_{1/2})]ₚ[Z⁹(Me)₂SiO_{1/2}]_{q}(SiO₂)ᵣ(Z¹⁰SiO_{3/2})ₛ (7)

(Z¹¹₃SiO_{1/2})ₜ(R¹¹₂SiO)ᵤ(R¹²SiO_{3/2})ᵥ[R¹³(Z¹²)SiO]_{w}(SiO₂)ₓ(Z¹³SiO_{3/2})_{y} (8)

wherein Me represents a methyl group; R⁴ to R¹³ each independently represents a monovalent hydrocarbon group, which may be substituted or non-substituted; Z⁴ to Z¹³ each independently represents a hydrolysable group; e, f, g, h, i, j and k each independently represents an integer of 0 to 10 with proviso that e+f≧3, g+h+i≧4 and j+k≧4; L, m, n, o, p, q, r, s, t, u, v, w, x and y each represents an integer of 0 to 20 with proviso that L+m+n+o≧4, p+q+r+s≧4 andt+u+v+w+x+y≧3.

Moreover, according to the invention, provided is a semiconductor device comprising internal porous film which is formable by a composition for forming porous film obtainable by hydrolysis and condensation, in an acidic or alkaline condition, of a mixture of 100 parts by weight of one or more compounds selected of the group consisting of hydrolysable silicon compounds represented by Formulas (1) and (2) and partially hydrolyzed and condensed products of the hydrolysable silicon compounds represented by Formulas (1) and (2):

R¹ ₐSiZ¹ ₄₋ₐ (1)

R² _{b}(Z²)_{3-b}Si-Y-Si(R³)_{c}Z³ _{3-c} (2)

wherein R¹, R² and R³ each independently represents a monovalent hydrocarbon group which may be substituted or non-substituted; Z¹, Z² and Z³ each independently represents a hydrolysable group; Y is independently selected from the group consisting of an oxygen atom, a phenylene group and an alkylene group having carbon atom number of 1 to 6; a independently represents an integer of 0 to 3; b and c each independently represents an integer of 0 to 2;
and 0.1 to 20 parts by weight of one or more cross-linking agents selected from the group consisting of structure-controlled cyclic or multi-branched oligomers represented by Formulas (3) to (8):

[R⁴(H)SiO]ₑ[R⁵(Z⁴)SiO]_{f} (3)

(R⁶SiO_{3/2})_{g}[R⁷(H)SiO]ₕ[R⁸(Z⁵)SiO]ᵢ (4)

(HSiO_{3/2})ⱼ(Z⁶SiO_{3/2})ₖ (5)

[H(Me)₂SiO_{1/2}]_{L}[Z⁷(Me)₂SiO_{1/2}]ₘ(R⁹SiO_{3/2})ₙ[R¹⁰(Z⁸)SiO]ₒ (6)

[H(Me)₂SiO_{1/2})]ₚ[Z⁹(Me)₂SiO_{1/2}]_{q}(SiO₂)ᵣ(Z¹⁰SiO_{3/2})ₛ (7)

(Z¹¹ ₃SiO_{1/2})ₜ(R¹¹ ₂SiO)ᵤ(R¹²SiO_{3/2})ᵥ[R¹³(Z¹²)SiO]_{w}(SiO₂)ₓ(Z¹³SiO_{3/2})_{y} (8)

wherein Me represents a methyl group; R⁴ to R¹³ each independently represents a monovalent hydrocarbon group which may be substituted or non-substituted; Z⁴ to Z¹³ each independently represents a hydrolysable group; e, f, g, h, i, j and k each independently represents an integer of 0 to 10 with proviso that e+f≧3, g+h+i≧4 and j+k≧4; L, m, n, o, p, q, r, s, t, u, v, w, x and y each represents an integer of 0 to 20 with proviso that L+m+n+o≧4, p+q+r+s≧4 and t+u+v+w+x+y≧3. In the semiconductor device of the invention, more specifically, the porous film can used as an insulator film in the multi-level interconnects.

Consequently, because the mechanical strength of the semiconductor device is secured and the hygroscopic property of the porous film is decreased, a semiconductor device containing an internal porous film having low dielectric constant is obtained. Because of lower dielectric constant of the insulator film, the parasitic capacitance of the area around the multi-level interconnects is decreased, leading to the high-speed operation and low power consumption of the semiconductor device.

Moreover, it is preferable in the semiconductor device of the invention that said porous film is between metal interconnections in a same layer of multi-level interconnects, or is between upper and lower metal interconnection layers. This arrangement can achieve a high-performing and highly reliable semiconductor device.

### Brief Description of Drawing

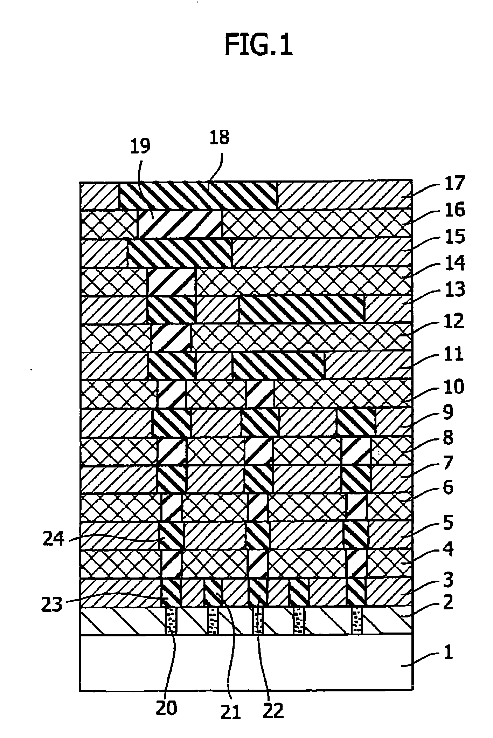

Fig. 1 is a schematic cross-sectional view of a semiconductor device of the invention.

### Best Mode for Carrying Out the Invention

According to the invention, in the hydrolysable silicon compound represented by Formula (1), R¹ represents a monovalent hydrocarbon group which may have one or more substituents, and may be preferably a straight chain or branched alkyl group having 1 to 7 carbons or an aryl group. The R¹ may include methyl, ethyl, propyl, isopropyl, butyl, isobutyl, sec-butyl, tert-butyl, pentyl, sec-pentyl, neopentyl, hexyl, heptyl, phenyl, o-tolyl, m-tolyl, p-tolyl and benzyl groups.

In Formula (1), Z¹ represents the monovalent hydrolysable group such as halogen, a hydroxyl group, an alkoxy group, an amino group and an acyl group. The halogen may include chlorine, bromine and iodine. The alkoxy group may include methoxy, ethoxy, propoxy, isopropoxy, isopropenoxy and butoxy groups. The amino group may include amino, dimethylamino and diethylamino groups. The acyl group may include acetoxy and benzoxy groups. In Formula (1), a represents an integer of 0 to 3 wherein a=1 means T-unit and a=0 means Q-unit.

The silane compound represented by Formula (1) may include, but is not limited to, silicon tetrachloride, methyl trichlorosilane, dimethyldichlorosilane, trimethylchlorosilane, trimethylchlorosilanol, tetramethoxysilane, tetraethoxysilane, tetrapropoxysilane, tetrapropenoxysilane, tetrabutoxysilane, methyltrimethoxysilane, methyltriethoxysilane, methyltripropoxysilane, ethyltrimethoxysilane, propyltrimethoxysilane, butyltrimethoxysilane, pentyltrimethoxysilane, hexyltrimethoxysilane, 2-ethylhexyltrimethoxysilane, phenyltrimethoxysilane, dimethyldimethoxysilane, dimethyldiethoxysilane, trimethylmethoxysilane, triethylmethoxysilane, butyldimethylmethoxysilane, methyltriaminosilane, dimethylbis(dimethylamino)silane, hexamethyldisilazane, tetraacetoxysilane, methyltriacetoxysilane, dimethyldiacetoxysilane, trimethylacetoxysilane and trimethylbenzoxysilane.

In the hydrolysable silicon compound in Formula (2), R² and R³ each represents a monovalent hydrocarbon group which may have one or more substituents, and may preferably represent a straight chain or branched alkyl group having 1 to 7 carbons or a aryl group wherein both groups may be substituted. Examples of R² and R³ may include those described as the examples of R¹.

In the hydrolysable silicon compound in Formula (2), Z² and Z³ each represents a monovalent hydrolysable group such as halogen, hydroxyl, alkoxy, amino and acyl groups. Examples of Z² and Z³ may include those described as the examples of Z¹.

The silicon compound represented by Formula (2) may include, but is not limited to, hexachlorodisiloxane, bis(trichlorvsilyl)methane, 1,2-bis(trichlorosilyl)ethane, 1,6-bis(trichlorosilyl)hexane, 1,4-bis(trichlorosilyl)phenylene, hexamethoxydisiloxane, 1,4-bis(trimethoxysilyl)phenylene, bis(trimethoxysilyl)methane, 1,2-bis(trimethoxysilyl)ethane, 1,6-bis(trimethoxysilyl)hexane, 1,4-bis(trimethoxysilyl)phenylene, hexaethoxydisiloxane, 1,4-bis(triethoxysilyl)phenylene, bis(triethoxysilyl)methane, 1,2-bis(triethoxysilyl)ethane, 1,6-bis(triethoxysilyl)hexane, 1,4-bis(triethoxysilyl)phenylene, 1,2-dimethyltetramethoxydisiloxane, 1,4-bis(methyldimethoxysilyl)phenylene, bis(methyldimethoxysilyl)methane, 1,2-bis (methyldimethoxysilyl) ethane, 1,6-bis(methyldimethoxysilyl)hexane, 1,4-bis(methyldimethoxysilyl)phenylene, 1,2-tetramethyldimethoxydisiloxane, 1,4-bis(dimethylmethoxysilyl)phenylene, bis(dimethylmethoxysilyl)methane, 1,2-bis(dimethylmethoxysilyl)ethane, 1,6-bis(dimethylmethoxysilyl)hexane and 1,4-bis(dimethylmethoxysilyl)phenylene.

According to the composition of the invention, a product obtained by partially hydrolyzing and condensing the hydrolysable silicon compounds represented by Formula (1) or (2) can be used. The "partially" means that the compound represented by (A) or (B) below can be used where the compound represented by (A) is the product obtained by partially hydrolyzing tetramethoxysilane instead of tetramethoxysilane and the compound represented by (B) which is the product obtained by partially hydrolyzing methyltrimethoxysilane instead of methyltrimethoxysilane.

(MeO)ₓₓSiₙₙOₘₘ (A)

wherein nn is an integer of 2 to 20 and mm is an integer of 1 to 30 with proviso that 2nn+2 ≥ xx+2mm.

(Meo)_{yy}(SiMe)ₒₒOₚₚ (B)

wherein oo is an integer of 2 to 20 and pp is an integer of 1 to 30 with proviso that 2oo+2 ≥ yy+oo+2pp.

Moreover, although the condition for hydrolysis at this time is not particularly limited, because the invention relates to the application for electronic material, the use of a metallic compound as basic catalyst is not preferable. According to the invention, catalyst which does not negatively affect the catalyst used for co-hydrolysis is desirable. For instance, it is preferable that there is no catalyst in alcohol solvent, or that a neutralization treatment is performed after hydrolysis in diluted hydrochloric acid (0.01N).

According to the invention, catalyst can be used during hydrolysis and condensation of the hydrolysable silicon compound. The catalyst may include inorganic acids such as hydrochloric acid, nitric acid and sulfuric acid; organic acids such as acetic acid, oxalic acid and citric acid; and basic catalysts such as ammonia and organic amine.

The hydrolysable silicon compound is already widely used as raw material for the coating composition for silica-based insulator film. For instance, according to Japanese Patent Provisional Publication No.2001-115028 discloses that the hydrolysable silicon comound is subjected to hydrolysis and condensation in the presence of an alkaline compound so that the composition for forming silica-based film having low dielectric constant and excellent mechanical strength can be provided. However, in order to lower the dielectric constant further, it is necessary to increase the mechanical strength of the film in order to raise an occupancy percentage of the pores. According to the invention, a cross-linking agent which has a controlled structure is added and condensed so that each building block that forms the porous is bonded firmly. Thus, the mechanical strength is attempted be increased.

According to the invention, structurally controlled cyclic or multi-branched oligomer represented by Formula (1) to (8) is used as a cross-linking agent together with a hydrolysable silicon compound. The R⁴ to R¹³ each represents a monovalent hydrocarbon group which may be substituted or non-substituted and represents preferably a straight chain or branched alkyl having 1 to 7 carbons or aryl group wherein both groups can be substituted. The R⁴ to R¹³ may include those described as the examples of R¹. The Z⁴ to Z¹³ each independently represents a hydrolysable group such as halogen, hydroxyl, alkoxy, amino and acyl groups.

The cross-linking having structural regularity can be prepared by forming a hydrolysate from the hydrolysable silicon compound containing Si-H and then substituting all or part of Si-H bond with a hydrolysable group.

The silicon compound represented by Formula (3) may include 1,3,5-trimethylcyclotrisiloxane, 1,3,5-trimethyl-1,3,5-trimethoxycyclotetrasilane, 1,3,5-trimethyl-1,3,5-triethoxycyclotetrasilane, 1,3,5,7-tetramethylcyclotetrasiloxane, 1,3,5,7-tetramethyl-1,3,5,7-tetramethoxycyclotetrasilane, 1,3,5,7-tetramethyl-1,3,5,7-tetraethoxycyclotetrasilane, 1,3,5,7,9-pentamethyl-1,3,5,7,9-pentamethoxycyclopentasiloxane.

An example of the silicon compound represented by Formula (4) may include a product obtained by partially hydrolyzing and condensing the compound represented by Formula (3)

An example of the silicon compound represented by Formula (5) may include a polyhedron silicon compound derivative shown in following formulas. In the formulas, Z¹⁴s may be same or different and each independently represents a hydrogen atom, an alkoxy group having 1 to 7 carbons, an amino group, an alkylamino group having 1 to 7 carbons or a dialkylamino group having 1 to 7 carbons.

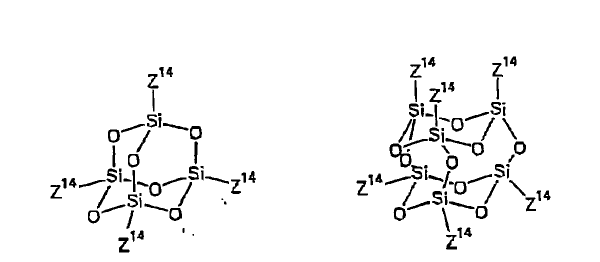

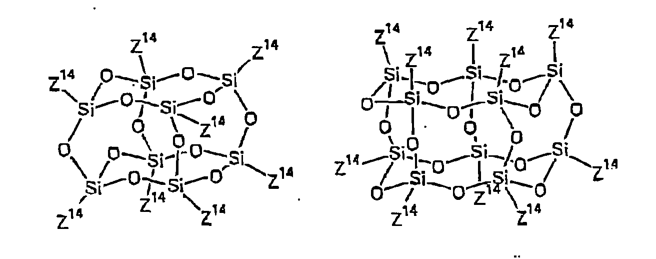

The silicon compound represented by Formula (6) may include branched siloxane and examples may include
tris(dimethylsiloxy)methylsilane,
tris(methoxydimethylsiloxy)methylsilane,
tris(ethoxydimethylsiloxy)methylsilane, tris(n-propoxydimethylsiloxy)methylsilane, tris(i-propoxydimethylsiloxy)methylsilane, tris(n-butoxydimethylsiloxy)methylsilane, tris(i-butoxydimethylsiloxy)methylsilane, tris(t-butoxydimethylsiloxy)methylsilane, tris(sec-butoxydimethylsiloxy)methylsilane,
tris(aminodimethylsiloxy)methylsilane,
tris(dimethylaminodimethylsiloxy)methylsilane, 1,1,3,3-tetrakis(dimethylsiloxy)-1,3-dimethyldisiloxane, 1,1,3,3-tetrakis(methoxydimethylsiloxy)-1,3-dimethyldisiloxane,
1,1,3,3-tetrakis(ethoxydimethylsiloxy)-1,3-dimethyldisiloxane, 1,1,3,3-tetrakis(dimethylaminodimethylsiloxy)-1,3-dimethyldisiloxane.

Examples of the compound represented by Formula (6) are shown in the following formulas. In the formulas, the Z¹⁵s may be same or different and each independently represents a hydrogen atom, an alkoxy group having 1 to 7 carbons, an amino group, an alkylamino group having 1 to 7 carbons or a dialkylamino group having 1 to 7 carbons. The R¹⁴s may be same or different and each independently represents a straight chain or branched alkyl having 1 to 7 carbons or an aryl group wherein both groups may be substituted.

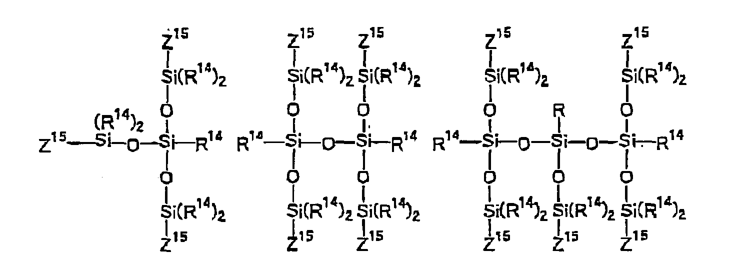

The silicon compound represented by Formula (7) can include branched siloxane and examples may include
tetrakis(dimethylsiloxy)silane,
tetrakis (methoxydimethylsiloxy) silane,
tetrakis(ethoxydimethylsiloxy)silane, tetrakis(n-propoxydimethylsiloxy)silane, tetrakis(i-propoxydimethylsiloxy)silane, tetrakis(n-butoxydimethylsiloxy)silane, tetrakis(i-butoxydimethylsiloxy)silane, tetrakis(t-butoxydimethylsiloxy)silane, tetrakis(sec-butoxydimethylsiloxy)silane,
tetrakis(dimethylaminodimethylsiloxy)silane,
hexakis(dimethylsiloxy)disiloxane,
hexakis(methoxydimethylsiloxy)disiloxane,
hexakis(dimethylsiloxy)cyclotrisiloxane,
hexakis(methoxydimethylsiloxy)cyclotrisiloxane,
octakis(dimethylsiloxy)cyclotetrasiloxane and
octakis(methoxydimethylsiloxy)cyclotetrasiloxane.

Examples of the compound represented by Formula (7) are shown in the following formulas. In the formulas, the Z¹⁶s may be same or different and each independently represents a hydrogen atom, an alkoxy group having 1 to 7 carbons, an amino group, an alkylamino group having 1 to 7 carbons or a dialkylamino group having 1 to 7 carbons. The R¹⁵s may be same or different and each independently represents an alkyl or aryl group wherein both groups can be substituted.

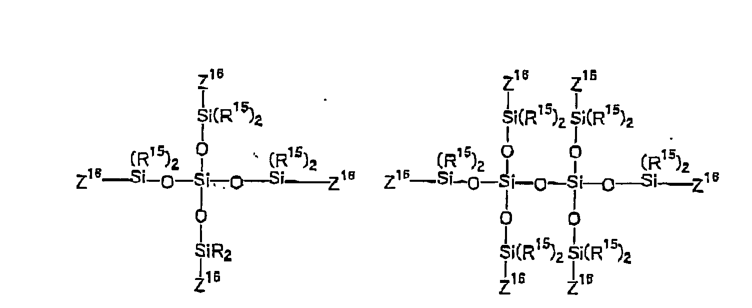

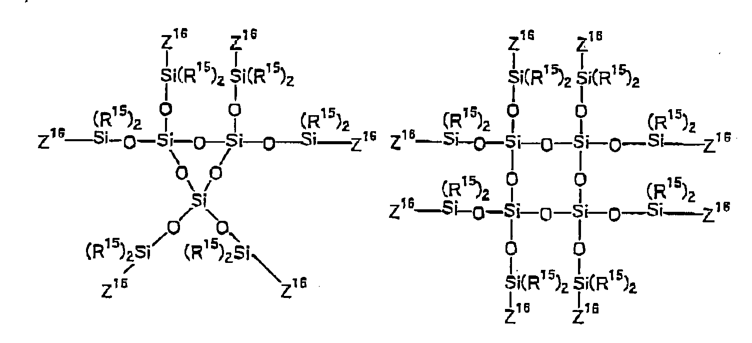

The silicon compound represented by Formula (8) may include siloxane having a functional terminal and examples may include 1,1,1,5,5,5-hexamethoxydimethyltrisiloxane, 1,1,1,5,5,5-hexaethoxydimethyltrisiloxane, 1,1,1,7,7,7-hexamethoxytetramethyltetrasiloxane, tris(trimethoxysiloxy)methylsilane, tetrakis(trimethoxysiloxy)disiloxane, 1,1,5,5-tetrakis(trimethoxy)dimethyltrisiloxane, tetrakis (trimethoxysiloxy) silane and 1,1,5,5,5-hexakis(trimethoxysiloxy)dimethyltrisiloxane.

Examples of the compound represented by Formula (8) is shown in the following formulas. In the formulas, the Z¹⁷s may be same or different and each independently represents a hydrogen atom, an alkoxy group having 1 to 7 carbons, an amino group, an alkylamino group having 1 to 7 carbons or a dialkylamino group having 1 to 7 carbons. The R¹⁶s may be same or different and each independently represents a straight chain or branched alkyl group or an aryl group wherein both groups can be substituted. Moreover, n₁s may be same or different and each independently represents an integer of 0 to 20.

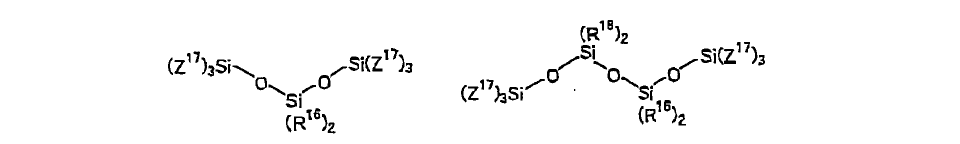

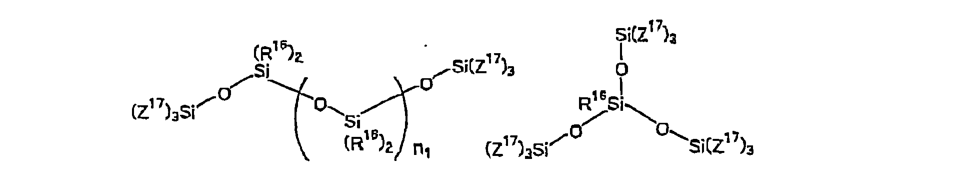

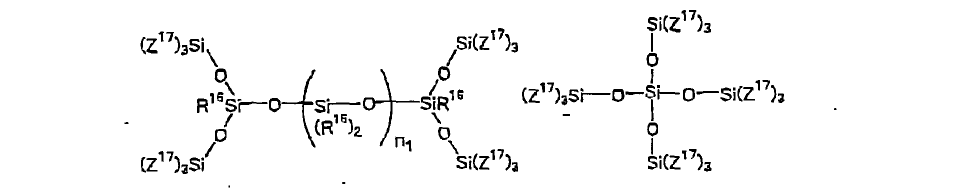

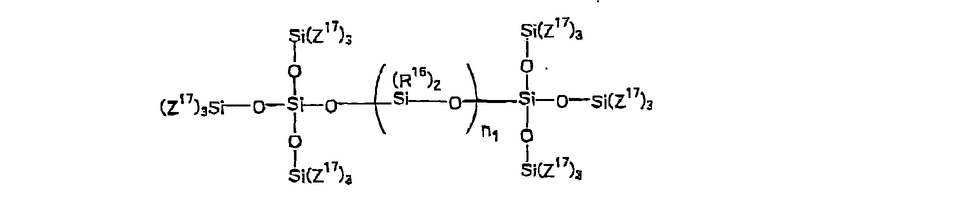

The Si-H in the compound can be partially or entirely converted to a hydrolysable alcohol as the result of reaction with alcohol or the like in the presence of metal catalyst and alkali. Alternatively the compound can be introduced into condensation reaction in the presence of alkali catalyst so that an introduction of a hydrolysable group and cross-linking reaction can be done in situ simultaneously.

Because the cross-linking agent is polyfunctional but has regulated structure, it does not easily generate gel during the cross-liking reaction so that it excels in storage stability.

The cross-linking agent can be added in 0.1 to 20, preferably 1 to 10, more preferably 2 to 5 parts by weight based on 100 parts by weight of the hydrolysate of the hydrolysable silicon compound represented by Formula (1) or (2). The cross-linking agent can be added together with the hydrolysable silicon compound for co-hydrolysis and co-condensation or parts by weight. Alternatively, it may also be added at the stage in which the hydrolysis and condensation of the hydrolysable silicon compound progresses to some degree.

The addition of the cross-linking agent have greatly improved the mechanical strength of the silica-based porous film produced by coating and sintering. Even dielectric constant has lowered slightly in comparison with the sintered film produced by the composition without the cross-linking agent.

The silane compound can be converted into a polymer solution by hydrolysis and condensation. The silane compound may be preferably converted into a polymer solution under an acidic condition of acidic catalyst in the presence of water through hydrolysis and condensation. The acid used herein may include inorganic acid such as hydrochloric acid, sulfuric acid and nitric acid; sulfonic acid such as methanesulfonic acid, benzenesulfonic acid, p-toluenesulfonic acid and trifluoromethanesulfonic acid; organic acid such as formic acid, acetic acid, propionic acid, oxalic acid, malonic acid, fumaric acid, maleic acid, tartaric acid, citric acid and malic acid; and phosphoric acid. The amount of water for the hydrolysis may be preferably 0.5 to 500 times, more preferably 10 to 100 times the mole number required for complete hydrolysis of the silane compound.

The polymer solution can also be synthesized under alkali condition. The base used herein may include ammonia; amines such as ethylamine, propylamine, diisopropylamine, triethylamine and triethanolamine; and alkali metal hydroxide and alkali earth metal hydroxide such as sodium hydroxide, potassium hydroxide and calcium hydroxide.

When the silicon compound in Formula (1) is converted to a polymer solution through hydrolysis and condensation, solvent such as alcohol which corresponds to the alkoxy group of the silicon compound may be present as well ad water. The solvent may include methanol, ethanol, isopropyl alcohol, butanol, propylene glycol monomethyl ether, propylene glycol monopropyl ether, propylene glycol monopropyl ether acetate, ethyl lactate and cyclohexanone. The solvent except water may be added in an amount of preferably 1 to 100 times, more preferably 5 to 20 times the weight of the silane compound.

The hydrolysis and condensation of the silane may be carried out under the same condition as used in usual hydrolysis and condensation reactions. The reaction temperature may be from 0°C to the boiling point of alcohol generated through hydrolysis and condensation, preferably room temperature to 60°C.

Although the reaction time is not limited, it may be usually from 10 minutes to 18 hours, more preferably 30 minutes to 3 hours.

The preferably weight-average molecular weight of the polymer obtained from the silane compound represented by Formula (1) may be 1,000 to 50,000,000 with Gel Permeation Chromatography (GPC) using the polystyrene conversion.

The composition of the invention can be used after diluted with solvent. The preferable solvent may include aliphatic hydrocarbon solvent, aromatic hydrocarbon solvent, ketone solvent, ether solvent, ester solvent, nitrogen-containing solvent and sulfur-containing solvent. The solvent may be used singly or in an admixture of two or more.

The aliphatic hydrocarbon solvent may include n-pentane, i-pentane, n-hexane, i-hexane, n-heptane, 2,2,2-trimethylpentane, n-octane, i-octane, cyclohexane and methylcyclohexane.

The aromatic hydrocarbon solvent may include benzene, toluene, xylene, ethylbenzene, trimethylbenzene, methylethylbenzene, n-propylbenzene, i-propylbenzene, diethylbenzene, i-butylbenzene, triethylbenzene, di-i-propylbenzene and n-amylnaphthalene.

The ketone solvent may include acetone, methyl ethyl ketone, methyl n-propyl ketone, methyl n-butyl ketone, methyl i-butyl ketone, trimethylnonanone, cyclohexanone, 2-hexanone, methylcyclohexanone, 2,4-pentanedione, acetonylacetone, diacetone alcohol, acetophenone and fenthion.

The ether solvent may include ethyl ether, i-propyl ether, n-butyl ether, n-hexyl ether, 2-ethyl hexyl ether, dioxolane, 4-methyldioxalane, dioxane, dimethyldioxane, ethylene glycol mono-n-butyl ether, ethylene glycol mono-n-hexyl ether, ethylene glycol monophenyl ether, ethylene glycol mono-2-ethylbutyl ether, ethylene glycol dibutyl ether, diethylene glycol monomethyl ether, diethylene glycol dimethyl ether, diethylene glycol monoethyl ether, diethylene glycol diethyl ether, diethylene glycol monopropyl ether, diethylene glycol dipropyl ether, diethylene glycol monobutyl ether, diethylene glycol dibutyl ether, tetrahydrofuran, 2-methyltetrahydrofuran, propylene glycol monomethyl ether, propylene glycol dimethyl ether, propylene glycol monoethyl ether, propylene glycol diethyl ether, propylene glycol monopropyl ether, propylene glycol dipropyl ether, propylene glycol monobutyl ether, dipropylene glycol dimethyl ether, dipropylene glycol diethyl ether, dipropylene glycol dipropyl ether and dipropylene glycol dibutyl ether.

The ester solvent may include diethyl carbonate, ethyl acetate, γ-butyrolactone, γ-valerolactone, n-propyl acetate, i-propyl acetate, n-butyl acetate, i-butyl acetate, sec-butyl acetate, n-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, dipropylene glycol monomethyl ether acetate, dipropylene glycol monoethyl ether acetate, dipropylene glycol mono-n-butyl ether acetate, glycol diacetate, methoxytriglycol acetate, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate and diethyl phthalate.

The nitrogen-containing solvent may include N-methylformamide, N,N-dimethylformamide, acetamide, N-methylacetamide, N,N-dimethylacetamide, N-methylpropionamide and N-methylpyrrolidone.

The sulfur-containing solvent may include dimethyl sulfide, diethyl sulfide, thiophene, tetrahydrothiophene, dimethylsulfoxide, sulfolane and 1,3-propanesultone.

The abovementioned solvent may be used for dilution or solvent exchange so that the concentration of the solute is controlled. Thus, the coating can result in the formation of the film having desirable thickness. The solvent for dilution may be used in an amount of preferably 2 to 500 times, more preferably 5 to 50 times the weight of the solute.

The film is formed using the composition for forming porous film of the invention. The composition of the invention may be applied on a substrate so that film is formed. The substrate on which the composition of the invention can be applied may include a semiconductor, glass, ceramic and metal. Any method which can be used for usual semiconductor device manufacturing can be used. The example may include spin-coat, scanning-coat, dipping and roller blade. The thickness of the formed film may be typically 0.2 to 20 µm for the interlevel insulating film. The formed film is heated in the next step usually called pre-bake in order to evaporate the solvent in the film and fix a shape of the coated film. The heating temperature here may be the temperature high enough to evaporate the solvent in the coating liquid.

The formed film is sintered in the second heating so that the condensation and the formation of the silica frame are completed.

It may be preferably that the first heating is at 80 to 250°C and the second heating is at 150 to 450°C. Thus, the composition is converted to porous film. The time for the first heating may be preferably about 0.1 minute to 1 hour, more preferably 1 to 5 minutes. The time for the second heating may be preferably about 1 minute to 1 hour, more preferably 1 to 5 minutes. It may be preferable to have the third heating step at 400 to 500°C for 1 hour to ensure the removal of the thermally decomposed residue. When the heating temperature is too low, the cross-linking of the silica does not progress sufficiently and curing is insufficient so that only film having low mechanical strength is formed. When the heating temperature is too high, the organic group on the silicon is decomposed and the strength of the film lowered, thereby making it unsuitable for the semiconductor device manufacturing process.

Whether or not the heating is carried out in an atmosphere or in an inert gas environment can cause difference in the distribution of pores and mechanical strength of the film. Accordingly, controlling the heating environment can control the physical properties of the film. Thus, any atmosphere can be useful and the heating environment is not limited.

The inert gase may include nitrogen gas and argon gas. According to the invention, the oxygen concentration in the inert gas is preferably kept low such as 5ppm or less so that the film having lower dielectric constant can be obtained by removal of the influence of oxygen after it is heated in the inert gas.

According the method embodiment of the invention, when the second heating is carried out in reduced pressure, the obtained film has lower dielectric constant because the decomposition and volatilization of the hydrolysable component or components are promoted and the influence of oxygen is removed.

The film obtained after heating in accordance with the method of the invention using the composition of the invention may typically have pores having diameter of 100 nm or less and porosity of 5 to 70%. The dielectric constant of the film may be typically 2.7 to 1.2, preferably 2.5 to 1.2. The mechanical strength (elastic modulus) of the film may be 5 GPa or more. Therefore, the film of the invention is suitable as an insulator film, especially as the interlevel insulator film of a highly integrated semiconductor.

The porous film of the present invention is particularly preferable as the interlevel insulator film of the interconnections in a semiconductor integrated circuit. The semiconductor device is required to reduce interconnection capacitance in order to prevent interconnection delay when highly integrated. Various means have been developed to achieve this, and one of them is to reduce the relative permittivity (dielectric constant) of the interlevel insulator film disposed between metal interconnections. When an interlevel insulator film is prepared by using the composition for forming a porous film of the present invention, the semiconductor device can be downsized and faster and consume less power.

However, there is a problem that when a porous film is prepared by introducing pores in the film so as to lower the dielectric constant, the mechanical strength of the film decreases as the density of the material composing the film decreases. The decrease in mechanical strength not only affects the strength of the semiconductor device itself but also causes exfoliation due to insufficient strength in a chemical mechanical polishing process, which is generally used in the fabrication process. Particularly, when used as the interlevel insulator film of the multi-level interconnects in a semiconductor, the porous film of the invention having high mechanical strength despite the porosity prevents such exfoliation. Consequently, the reliability of the produced semiconductor is greatly improved.

The embodiments of the semiconductor device of the present invention will be described below. Fig. 1 shows a schematic cross-sectional view of an example of the semiconductor device of the present invention.

In Fig. 1, the substrate 1 is an Si semiconductor substrate such as an Si substrate or an SOI (Si-on-insulator) substrate; however, it can be a compound semiconductor substrate such as SiGe or GaAs. The interlevel insulator films include the interlevel insulator film 2 of the contact layer; the interlevel insulator films 3, 5, 7, 9, 11, 13, 15, and 17 of the interconnection layers; and the interlevel insulator films 4, 6, 8, 10, 12, 14, and 16 of the via layers. The interconnection layers corresponding to the lowermost interlevel insulator film 3 through the uppermost insulator film 17 are abbreviated as M1, M2, M3, M4, M5, M6, M7, and M8, respectively. The via layers corresponding to the lowermost interlevel insulator film 4 through the uppermost insulator film 16 are abbreviated as V1, V2, V3, V4, V5, V6, and V7, respectively. Although some of the metal interconnections are referred to with the numbers 18 and 21 to 24, the other regions with the same pattern not labeled with numbers indicate metal interconnections. The via plug 19 is made from a metal. In the case of copper interconnection, copper is generally used. The regions having the same pattern as the via plug 19 represent via plugs although they are not labeled with numbers in the drawing. The contact plug 20 is connected to the gate of the transistor (not illustrated) formed on the top surface of the substrate 1 or to the substrate. Thus, the interconnection layers and the via layers are alternately stacked, and multilayer interconnections generally indicate M1 and regions higher than M1. In general, M1 to M3 are called local interconnections, M4 and M5 are called intermediate interconnections or semi-global interconnections, and M6 to M8 are called global interconnections.

In the semiconductor device of the present invention, the porous film of the present invention is used as one or more of the interlevel insulator films 3, 5, 7, 9, 11, 13, 15, and 17 of the interconnection layers or the insulator films 4, 6, 8, 10, 12, 14, and 16 of the via layers.

For example, when the porous film of the present invention is used for the interlevel insulator film 3 of the interconnection layer (M1), the interconnection capacitance between the metal interconnection 21 and the metal interconnection 22 can be greatly reduced. When the porous film of the present invention is used for the interlevel insulator film 4 of the via layer (V1), the interconnection capacitance between the metal interconnection 23 and the metal interconnection 24 can be greatly reduced. Using the porous film with a low relative permittivity of the present invention as an interconnection layer can greatly reduce the metal interconnection capacitance in the same layer. On the other hand, using the porous film with a low relative permittivity of the present invention as a via layer can greatly reduce the capacitance between the upper and lower metal interconnection layers. Therefore, using the porous film of the present invention for all of the interconnection layers and the via layers can greatly reduce the parasitic capacitance of the interconnections.

When the porous film of the invention is used as an insulator film of the interconnects, the conventional problem of the increased dielectric constant caused by the film having absorbed moisture during the lamination of porous film to form the multi-level interconnects does not happen. Consequently, a semiconductor having high performance and less power consumption can be realized.

The porous film of the present invention enables a semiconductor device to have higher mechanical strength by its high mechanical strength, thereby greatly improving the yield of the fabrication and the reliability of the semiconductor device.

The invention will be described specifically through the following synthetic examples, examples and comparative example, but is not limited to the examples.

### Synthetic Examples 1 to 6

The 3.33 g of tetramethoxysilane and 2.50 g of methyltrimethylsilane, 100 ml of ethanol solvent, 53.3 g of pure water and 0.83 g of 25% ammonia water were placed in a 300ml flask and were mixed for 3 hours at 60°C. Then, 0.25 g of cross-linking agent shown in Table 1 and 33 g of propylene glycol propyl ether were added thereto and the reaction was continure for further 1 hour. Next, the ethanol solvent, methanol generated by hydrolysis and water were evaporated under reduced pressure of 5.3 kPa at 60°C to obtain residue. Propylene glycol propyl ether (PnP) was then appropriately added to the residue so that a solution of NV8% was obtained. The NV8% means a concentration of 8% based on the calculated conversion to silica after the sintering at 400°C for 1 hour.

**Table 1**

| Syn. Ex. No. | hydrolyzable Silicon compound | | cross-linking agent | | | | | | ammonia water | PnP |
|---|---|---|---|---|---|---|---|---|---|---|
| | Si(OMe)₄ (g) | MeSi(OMe)₃ (g) | LS-8680 *(g) | H4 (g) | T^{H}-8 (g) | M^{H}3T (g) | M^{H}40 (g) | Siloxane-A (g) | (g) | **(g) |
| 1 | 3.33 | 2.50 | 0.25 | | | | | | 0.83 | 33.3 |
| 2 | 3.33 | 2.50 | | 0.25 | | | | | 0.83 | 33.3 |
| 3 | 3. 33 | 2. 50 | | | 0.25 | | | | 0.83 | 33. 3 |
| 4 | 3.33 | 2.50 | | | | 0.25 | | | 0.83 | 33.3 |
| 5 | 3.33 | 2.50 | | | | | 0.25 | | 0.83 | 33. 3 |
| 6 | 3.33 | 2.50 | | | | | | 0.25 | 0.83 | 33.3 |
| 7 | 3.33 | 2.50 | | | | | | | 0.83 | 33.3 |

| | | | | | | | | | | |
|---|---|---|---|---|---|---|---|---|---|---|
| * LS-8680 is a product grade by Shin-Etsu Chemical Co., Ltd. | | | | | | | | | | |
| ** PnP represents propylene glycol propyl ether. | | | | | | | | | | |

The cross-linking agents used are shown in chemical formulas below.

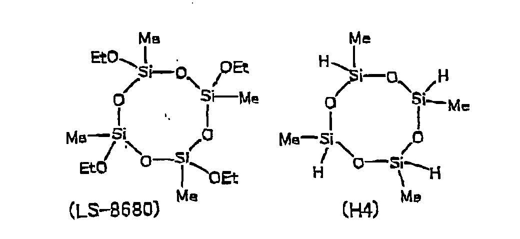

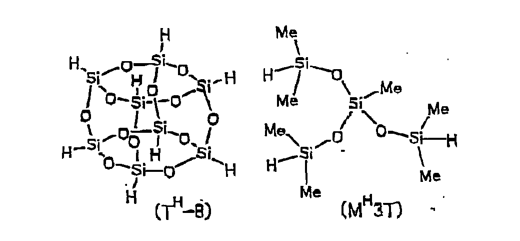

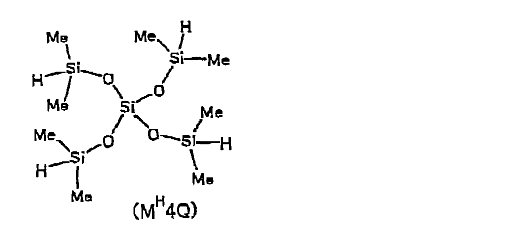

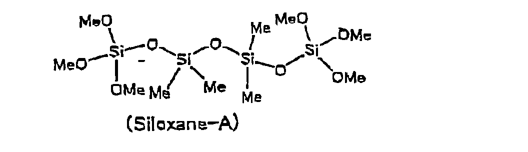

### Examples 1 to 7

Using the composition described in Synthetic Examples and Table 1, spin-coating was performed on a silicon wafer. It was pre-baked at 120°C for 2 minutes to remove the solvent and further heated at 230°C for 3 minutes. Then, it was heated at 425°C for 1 hour under a nitrogen gas stream so that it was matured.

The obtained film was evaluated. The film thickness was measured with an ellipsometer and the dielectric constant was measured with mercury probe 495CV system (Japan SSM, Solid State Mesurements Corporation). The hardness and the modulus were measured with nano-indentor SA2 (Toyo Technica, MTS Corporation). The results are shown in Table 2.

### Comparative Example 1

Using the composition of Synthetic Example 7 comprising no cross-linking agent, the experiment was carried out under the reaction condition and scale. The properties of the obtained silica porous film are shown in Table 2.

**Table 2**

| | composition | evaluation results of film | | | | |
|---|---|---|---|---|---|---|
| | | refractive index | thickness (A) | dielectric constant | hardness (GPa) | modulus (GPa) |
| Ex.1 | Syn. Ex.1 | 1. 2523 | 4543 | Z.13 | 0.53 | 5.9 |
| Ex.2 | Syn.Ex.2 2 | 1. 2612 | 4789 | 2.12 | 0.54 | 6.1 |
| Ex. 3 | Syn.Ex.3 | 1.2557 | 4438 | 2.15 | 0.54 | 6.1 |
| Ex. 4 | Syn.Ex.4 | 1.2347 | 4489 | 2.17 | 0. 52 | 5.8 |
| Ex. 5 | Syn. Ex. 5 | 1. 2478 | 4327 | 2.18 | 0. 52 | 5. 9 |
| Ex. 6 | Syn.Ex.6 | 1.2385 | 4228 | 2.14 | 0.51 | 5.4 |
| Comp.Ex.1 | Syn.Ex.7 | 1.257 | 4512 | 2. 20 | 0.42 | 4.1 |

### Industrial Applicability

The composition of the invention excels in storage stability and can form porous film having low dielectric constant which is flat and uniform as well as having high mechanical strength. The film is suitable for an insulator film of the multi-level interconnects in the semiconductor processing. When the porous film formable by the composition of the invention is used as an insulator film of the multi-level interconnects, a high-performing and highly reliable semiconductor device can be realized.

## Claims

1. A composition for forming porous film obtainable by hydrolysis and condensation, in an acidic or alkaline condition, of a mixture of
100 parts by weight of one or more compounds selected of the group consisting of hydrolysable silicon compounds represented by Formulas (1) and (2) and partially hydrolyzed and condensed products of the hydrolysable silicon compounds represented by Formulas (1) and (2):
R¹ ₐSiZ¹ ₄₋ₐ (1)
R² _{b}(Z²)_{3-b}Si-Y-Si(R³)_{c}Z³ _{3-c} (2)
wherein R¹, R² and R³ each independently represents a monovalent hydrocarbon group which may be substituted or non-substituted; Z¹, Z² and Z³ each independently represents a hydrolysable group; Y is independently selected from the group consisting of an oxygen atom, a phenylene group and an alkylene group having carbon atom number of 1 to 6; a independently represents an integer of 0 to 3; b and c each independently represents an integer of 0 to 2;
and 0.1 to 20 parts by weight of one or more cross-linking agents selected from the group consisting of structure-controlled cyclic or multi-branched oligomers represented by Formulas (3) to (8):
[R⁴(H)SiO]ₑ[R⁵(Z⁴)SiO]_{f} (3)
(R⁶SiO_{3/2})_{g}[R⁷(H)SiO]ₕ[R⁸(Z⁵)SiO]ᵢ (4)
(HSiO_{3/2})ⱼ(Z⁶SiO_{3/2})ₖ (5)
[H(Me)₂SiO_{1/2}]_{L}[Z⁷(Me)₂SiO_{1/2}]ₘ(R⁹SiO_{3/2})ₙ[R¹⁰(Z⁸)SiO]ₒ (6)
[H(Me)₂SiO_{1/2})]ₚ[Z⁹(Me)₂SiO_{1/2}]_{q}(SiO₂)ᵣ(Z¹⁰SiO_{3/2})ₛ (7)
(Z¹¹ ₃SiO_{1/2})ₜ(R¹¹ ₂SiO)ᵤ(R¹²SiO_{3/2})ᵥ[R¹³(Z¹²)SiO]_{w}(SiO₂)ₓ(Z¹³SiO_{3/2})_{y} (8)
wherein Me represents a methyl group; R⁴ to R¹³ each independently represents a monovalent hydrocarbon group which may be substituted or non-substituted; Z⁴ to Z¹³ each independently represents a hydrolysable group; e, f, g, h, i, j and k each independently represents an integer of 0 to 10 with proviso that e+f≥3 g+h+i≧4 and j+k≧4; L, m, n, o, p, q, r, s, t, u, v, w, x and y each represents an integer of 0 to 20 with proviso that L+m+n+o≧4, p+q+r+s≧4 and t+u+v+w+x+y≧3.

2. The composition for forming film according to Claim 1 further comprising a solvent.

3. A method for forming porous film comprising a step of coating a substrate with said composition of Claim 1 or 2 to form film and a step of forming pores in the film.

4. The method for forming porous film according to Claim 3 wherein said step of forming pores comprise a first heating treatment at temperature high enough to evaporate the solvent in said film and a second heating treatment.

5. A porous film obtainable from said composition of Claim 1 or 2.

6. An interlevel insulator film formable by said composition of Claim 1 or 2.

7. A semiconductor device comprising internal porous film which is formable by a composition for forming porous film obtainable by hydrolysis and condensation, in an acidic or alkaline condition, of a mixture of
100 parts by weight of one or more compounds selected of the group consisting of hydrolysable silicon compounds represented by Formulas (1) and (2) and partially hydrolyzed and condensed products of the hydrolysable silicon compounds represented by Formulas (1) and (2):
R¹ ₐSiZ¹ ₄₋ₐ (1)
R² _{b}(Z²)_{3-b}Si-Y-Si(R³)_{c}Z³ _{3-c} (2)
wherein R¹, R² and R³ each independently represents a monovalent hydrocarbon group which may be substituted or non-substituted; Z¹, Z² and Z³ each independently represents a hydrolysable group; Y is independently selected from the group consisting of an oxygen atom, a phenylene group and an alkylene group having carbon atom number of 1 to 6; a independently represents an integer of 0 to 3; b and c each independently represents an integer of 0 to 2;
and 0.1 to 20 parts by weight of one or more cross-linking agents selected from the group consisting of structure-controlled cyclic or multi-branched oligomers represented by Formulas (3) to (8):
[R⁴(H)SiO]ₑ[R⁵(Z⁴)SiO]_{f} (3)
(R⁶SiO_{3/2})_{g}[R⁷(H)SiO]ₕ[R⁸(Z⁵)SiO]ᵢ (4)
(HSiO_{3/2})ⱼ(Z⁶SiO_{3/2})ₖ (5)
[H(Me)₂SiO_{1/2}]_{L}[Z⁷(Me)₂SiO_{1/2}]ₘ(R⁹SiO_{3/2})ₙ[R¹⁰(Z⁸)SiO]ₒ (6)
[H(Me)₂SiO_{1/2})]ₚ[Z⁹(Me)₂SiO_{1/2}]_{q}(SiO₂)ᵣ(Z¹⁰SiO_{3/2})ₛ (7)
(Z¹¹ ₃SiO_{1/2})ₜ(R¹¹ ₂SiO)ᵤ(R¹²SiO_{3/2})ᵥ[R¹³(Z¹²)SiO]_{w}(SiO₂)ₓ(Z¹³SiO_{3/2})_{y} (8)
wherein Me represents a methyl group; R⁴ to R¹³ each independently represents a monovalent hydrocarbon group which may be substituted or non-substituted; Z⁴ to Z¹³ each independently represents a hydrolysable group; e, f, g, h, i, j and k each independently represents an integer of 0 to 10 with proviso that e+f≧3, g+h+i≧4 and j+k≧4; L, m, n, o, p, q, r, s, t, u, v, w, x and y each represents an integer of 0 to 20 with proviso that L+m+n+o≧4, p+q+r+s≧4 and t+u+v+w+x+y≧3.

8. The semiconductor device according to Claim 7 wherein said porous film is between metal interconnections in a same layer of multi-level interconnections, or is between upper and lower metal interconnection layers.
